Europäisches Patentamt

European Patent Office

Office européen des brevets

(19)

(11) Veröffentlichungsnummer : **0 068 394**
**B1**

(12) **EUROPÄISCHE PATENTSCHRIFT**

(45) Veröffentlichungstag der Patentschrift :
21.11.85

(21) Anmeldenummer : 82105434.3

(22) Anmeldetag : 21.06.82

(51) Int. Cl.⁴ : **G 01 R 31/34, H 02 P 7/36,
G 06 G 7/18**

(54) Vorrichtung zum Bestimmen einer aus dem Integral der Lastspannung und ggf. dem Laststrom zu bildenden Betriebsgrösse einer Last, insbesondere des Flusses einer Drehfeldmaschine.

(30) Priorität : 30.06.81 DE 3125748

(43) Veröffentlichungstag der Anmeldung :
05.01.83 Patentblatt 83/01

(45) Bekanntmachung des Hinweises auf die Patenterteilung : 21.11.85 Patentblatt 85/47

(84) Benannte Vertragsstáaten :
AT BE CH DE FR GB IT LI LU NL SE

(56) Entgegenhaltüngen :
DE-A- 2 907 595
DE-B- 2 833 593
Die Akte enthält technische Angaben, die nach dem
Eingang der Anmeldung eingereicht wurden und die
nicht in dieser Patentschrift enthalten sind.

(73) Patentinhaber : Siemens Aktiengesellschaft
Berlin und München Wittelsbacherplatz 2
D-8000 München 2 (DE)

(72) Erfinder : Reng, Leonhard, Dipl.-Ing.
Georg-Krauss-Strasse 8
D-8520 Erlangen (DE)

**Beschreibung**

Die Erfindung betrifft eine Vorrichtung zum Bestimmen einer Rechengröße, die eine Betriebsgröße einer Last abbildet, gemäß dem Oberbegriff des Anspruches 1. Die Erfindung betrifft ferner eine Vorrichtung zum Bestimmen einer Rechengröße, die einer Meßspannung zugeordnet ist, entsprechend dem Oberbegriff des Anspruches 3. Derartige Vorrichtungen sind aus der DE-C-2 833 593 bekannt.

Um aus einer oberwellenbehafteten oder anderweitig gestörten Wechselspannung in einer Rechenschaltung eine Rechengröße zu ermitteln (z. B. um aus der Speisespannung einer angeschlossenen Last in einer Steuereinrichtung eine Steuergröße für die Last zu bilden), werden häufig Glättungsglieder verwendet, die für Spannungen niedriger Frequenz eine unverminderte Durchlässigkeit besitzen, hohe Frequenzen jedoch dämpfen. Derartige Glättungsglieder besitzen einen Frequenzgang $1/(1 + s \cdot T)$ mit der Zeitkonstanten T und dem Laplace-Operator s und sind in der Regel als eine Integrationsschaltung mit einem zum Integrationskondensator parallelgeschalteten Widerstand ausgeführt. Neben der Dämpfung der unerwünschten Oberwellen bewirken sie eine Phasenverschiebung der Wechselspannung, die in Kauf genommen werden muß, da zu deren Kompensation ein Übertragungsglied mit der Übertragungsfunktion $(1 + s \cdot T)$ benötigt würde, das ihrerseits die gedämpften Oberwellen wiederum verstärken würde.

Den erwähnten Rechenschaltungen kann die der Berechnung der Rechengröße zugrunde liegende Lastspannung in der Regel nicht direkt aufgeschaltet werden, da einerseits eine galvanische Trennung der Rechenschaltung von dem Spannungsnetz nötig ist, andererseits die in der Rechenschaltung verwendeten Operationsverstärker und anderen Bauelemente nur bei einem verhältnismäßig niedrigen, meist erheblich unter dem Lastspannungspegel liegenden Spannungspegel arbeiten. Es sind daher zwischen dem Spannungsnetz und der Rechenschaltung Meßwandler mit einer galvanischen Trennung und einem entsprechenden Übertragungsverhältnis erforderlich.

Für den hier bevorzugt betrachteten Anwendungsfall, daß mit der Spannung eine Drehfeldmaschine gespeist wird, benötigt man für eine hochdynamische Steuerung der Drehfeldmaschine eine Information über die Drehfeldrichtung. Diese wird erhalten, wenn man den magnetischen Fluß der Maschine durch Integration der EMK bildet, wobei die EMK aus der Maschinenspannung U und ggf. bei Berücksichtigung des vom Ständerstrom I hervorgerufenen ohmschen Ständerspannungsabfalls und der induktiven Streuspannung aus dem Maschinenstrom berechnet wird gemäß der Beziehung.

$$\underline{\psi} = \int (\underline{U} - r \cdot \underline{I}) \, dt - x \cdot \underline{I} \, ,$$

wobei mit r und x die Maschinenparameter für den ohmschen Ständerwiderstand und die Streuinduktivität bezeichnet sind. Dieser Fluß wird in Betrag und Richtung dadurch ermittelt, daß $\underline{\psi}$, $\underline{U}$ und $\underline{I}$ als Vektoren behandelt werden und diese Beziehung für die Komponenten dieser Vektoren getrennt ausgewertet wird. Hierzu wird für jede Komponente eine Integrationsschaltung verwendet, der die Differenz $U - r \cdot I$ der entsprechenden Vektorkomponenten aufgeschaltet wird. Dem Ausgang des Integrators kann dann noch an einem Summationsglied das Produkt $- x \cdot I$ zur Berücksichtigung der induktiven Streuspannung überlagert werden (DE-C-2 833 593).

In der Integrationsschaltung auftretende Integrationsfehler können nach DE-A-2 907 595 in einer nachgeschalteten Rechenstufe kompensiert werden, die einen Eingang für den Frequenzistwert aufweist und eine Drehung des integrierten Vektors vornimmt. Auf niedrige Frequenzen, bei denen eine Division durch den Frequenzistwert zu einer Überschreitung des Rechenbereiches verwendeter Dividierer führen würde, kann der Betriebsbereich der Rechenstufe ausgedehnt werden, indem am Frequenzeingang eine Multiplikation vorgenommen wird, die am Ausgang wieder rechnerisch kompensiert wird. Dadurch wird zwar der Betriebsbereich erweitert, die Rechengenauigkeit aber nicht verbessert. Die bereits nach der DE-C-2 833 593 bekannten, der Integrationsschaltung vorgeschalteten Schaltungsteile zur Erfassung von Strom und Spannung sowie die Verarbeitung der korrigierten integrierten Größen werden unverändert übernommen.

Mit Hilfe der z. B. nach der DE-C-2 833 593 ermittelten Rechengröße für den Fluß kann nun die Drehfeldmaschine so gesteuert werden, daß durch Vorgabe der zum Fluß parallelen Komponente des Ständerstromes der Fluß auf einem vorgegebenen (insbesondere konstanten) Sollwert gehalten wird, während mit der zum Fluß senkrechten Komponente das Drehmoment gesteuert wird (feldorientierter Betrieb).

Der erwähnten Integrationsschaltung wird der vom ohmschen Ständerwiderstand r bestimmte Ständerspannungsabfall $r \cdot I$ von einer an dem Maschinenanschluß angeordneten Strommeßeinrichtung als eine zu $r \cdot I$ proportionale Eingangsgröße eingegeben. Im Normalbetrieb ändert sich der Betrag I des Ständerstromes nur geringfügig, so daß der Pegel dieser Eingangsgröße stets erheblich über den Meßfehlern der Stromerfassungseinrichtung liegt, die ihrerseits auch der galvanischen Trennung der Integrationsschaltung von den Maschinenanschlüssen dient. Die Maschinenspannung U wird von einem Meßwandler erfaßt, der unter galvanischer Trennung von den Motoranschlüssen ein dem Proportionalitätsfaktor der Stromerfassungseinrichtung angepaßtes Übertragungsverhältnis besitzt, so daß nunmehr in der Integrationsschaltung durch Integration von $u' - r \cdot i$ und ggf. unter Berücksichtigung einer ebenfalls an der Stromerfassungseinrichtung abgegriffenen Größe x · í eine Rechengröße ψ′ gebildet wird. Diese Rechengröße ist unter Berücksichtigung eines Normierungsfaktors $\omega_N$, der eine geeignet vorgegebene Bezugsfrequenz darstellt, als eine Komponente des mathematisch errechneten Flusses $\underline{\psi}′ = \omega_N \cdot \underline{\psi}$ der entsprechenden Komponente des tatsächlichen Flusses

$$\underline{\psi} = \int (\underline{U} - r \cdot \underline{I})\,dt - x \cdot \underline{I}$$

proportional.

Da bei einer Steuerung, bei der der Fluß $\underline{\psi}$ stets auf einem verhältnismäßig hohen Sollwert gehalten wird, die Ständerspannung mit abnehmender Frequenz ebenfalls abnehmen muß, tritt jedoch der Fall auf, daß bei einer Annäherung der Drehzahl an eine untere, für den normalen Betriebsbereich vorgesehene Grenzfrequenz der Lastspannungspegel so weit absinkt, daß ein z. B. durch die Offset-Spannung des Meßwandlers hervorgerufener Gleichanteil in der Größe u′ sowie die Meßfehler des Meßwandlers zu einer derartigen Verfälschung der Eingangsgröße u′ und der Rechengröße ψ′ führen, daß eine ordnungsgemäße Steuerung nicht mehr möglich ist.

Der Erfindung liegt die Aufgabe zugrunde, bei einer Vorrichtung, wie sie im Oberbegriff des Anspruches 1 oder 3 angegeben ist, den Einfluß des Übertragungsfehlers des Meßwandlers auch bei niedrigen Frequenzen gering zu halten.

Diese Aufgabe wird erfindungsgemäß gelöst durch die Merkmale des Anspruchs 1 bzw. 3, die insbesondere bei einem Flußrechner zur Bestimmung einer dem Fluß einer Drehfeldmaschine zugeordneten Rechengröße verwendet werden.

Die Erfindung geht dabei davon aus, daß eine dem Meßwandler vorgeschaltete Integrationsschaltung mit der Übertragungsfunktion $k/(1 + s \cdot k/\omega_N)$ einen Amplitudengang aufweist, bei dem Spannungen bis zu einer Frequenz $\omega_N/k$ um den Faktor k verstärkt werden, während der Verstärkungsfaktor bei höheren Frequenzen linear abnimmt. Bei entsprechender Auslegung dieser vorgeschalteten Integrationsschaltung kann also erreicht werden, daß selbst bei einem sehr kleinen Lastspannungspegel am Eingang des Meßwandlers ein gegenüber dem Übertragungsfehler hinreichend großes Signal anliegt. Gelingt es nun, dem Ausgang des Meßwandlers eine Schaltungsanordnung mit der inversen Übertragungsfunktion nachzuordnen, so wird die durch die vorgeschaltete Integrationsschaltung hervorgerufene Verzerrung des Lastspannungspegels rückgängig gemacht und gleichzeitig auch der dabei hervorgerufene Phasengang kompensiert. Diese nachgeordnete Schaltungsanordnung kann als eigenes Bauglied ausgeführt sein, oder insbesondere in dem Fall, daß der anschließende Schaltungsteil selbst eine Integrationsschaltung enthält, in diese Schaltung auf andere Weise integriert sein.

Bei dieser Anordnung wird demnach praktisch die Proportionalitätskonstante zwischen der Lastspannung und dem Ausgangssignal des Meßwandlers entsprechend dem jeweiligen Frequenzbereich verändert, wobei jedoch diese Bereichsänderung nicht diskontinuierlich in Form einer Bereichsumschaltung erfolgt, sondern kontinuierlich und ohne ein Umschalten in der Beschaltung des Meßwandlers.

Anhand zweier bevorzugter Ausführungsbeispiele und zweier Figuren wird die Erfindung näher erläutert.

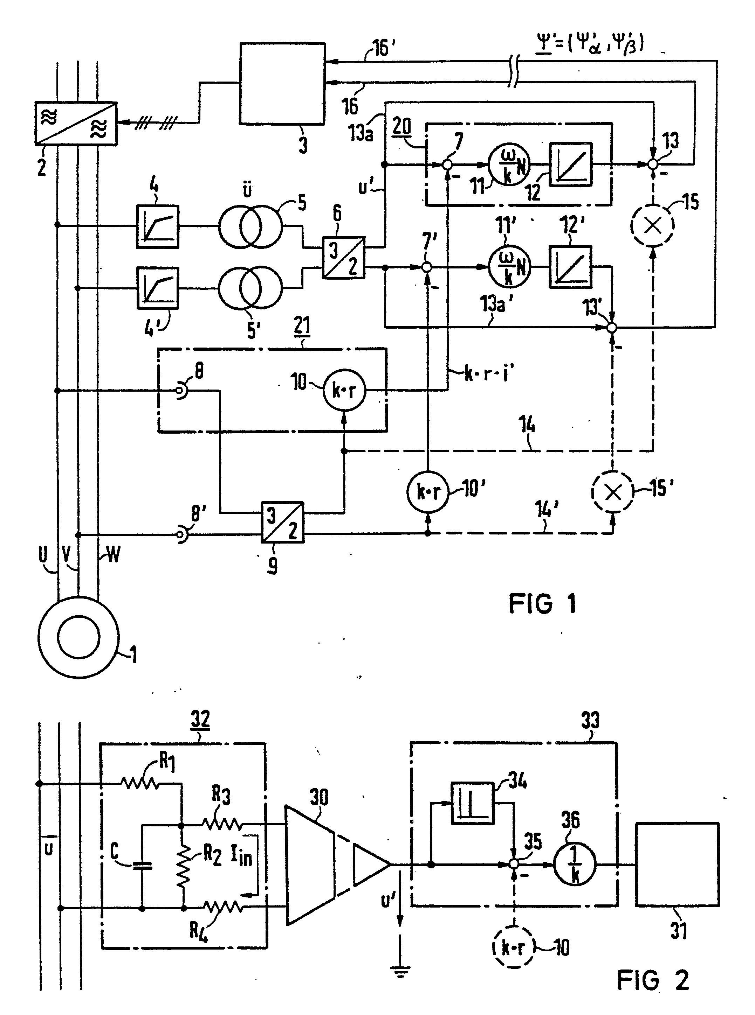

Fig. 1 zeigt eine als Flußrechner für eine Drehfeldmaschine verwendete Vorrichtung gemäß der Erfindung und Fig. 2 stellt schematisch eine allgemeiner verwendbare erfindungsgemäße Vorrichtung dar.

Die Erfindung wird zunächst für die bevorzugte Anwendung bei dem Betrieb einer Drehfeldmaschine 1 erläutert, die über ihre Anschlüsse U, V, W aus einem an ein Drehstromnetz angeschlossenen Umrichter gespeist wird, der seinerseits die Steuersignale für seine Ventile aus einer Steuereinrichtung 3 erhält. Für den eingangs erläuterten feldorientierten Betrieb der Drehfeldmaschine benötigt die Steuereinrichtung 3 eine Information über Betrag und Richtung des Flusses, der seinerseits aus einer Integration der von der Drehfeldmaschine induzierten EMK hervorgeht und aus der Ständerspannung $\underline{U}$ sowie dem Ständerstrom $\underline{I}$ unter Berücksichtigung des vom Ständerstrom am Ständerwiderstand r erzeugten ohmschen Ständerspannungsabfalls und der an der Streuinduktivität x auftretenden Streuspannung erfaßt werden kann. In bekannter Weise können Ständerstrom und Ständerspannung aus den Phasenströmen und Phasenspannungen zu einem resultierenden Stromvektor bzw. Spannungsvektor zusammengesetzt werden, so daß für den Fluß die vektorielle Beziehung.

$$\underline{\psi} = \int (\underline{U} - r \cdot \underline{I})\,dt - x \cdot \underline{I} \tag{1}$$

gilt. Vorteilhaft werden diese Vektoren durch ihre mit den Indizes $\alpha$ und $\beta$ bezeichneten Komponenten bezüglich eines ortsfesten, kartesischen Koordinatensystems betrachtet, so daß sich die beiden Komponentengleichungen

$$\psi_\alpha = \int (U_\alpha - r \cdot I_\alpha)\,dt - x \cdot I_\alpha \tag{2}$$

$$\psi_\beta = \int (U_\beta - r \cdot I_\beta)\,dt - x \cdot I_\beta \tag{3}$$

3

ergeben. Diese beiden Komponenten werden nun dadurch berechnet, daß die Spannungen an zwei Phasen U, V der Ständerwicklung abgegriffen und jeweils über eine (« zweite ») Integrationsschaltung 4, 4' einem Meßwandler 5, 5' zugeführt werden. Aus den beiden auf diese Weise ermittelten Phasenspannungen, durch die Richtung und Betrag eines dem Ständerspannungsvektor $\underline{U}$ zugeordneten Spannungsvektors bestimmt sind, bildet der Komponentenwandler 6 die kartesischen Komponenten eines entsprechenden Vektors $\underline{U}'$, wobei jede Komponente einem Summationsglied 7 bzw. 7' zugeführt ist.

Die Ströme in den Phasen U und V werden über Stromwandler 8, 8' abgegriffen und ebenfalls über einen Komponentenwandler 9 in die kartesischen Komponenten eines dem Ständerstromvektor $\underline{I}$ proportionalen Stromvektors $\underline{I}'$ umgewandelt. Diese beiden kartesischen Komponenten werden über erste Proportionalitätsglieder 10, 10', den Summationsgliedern 7, 7' negativ aufgeschaltet. Diese Summationsglieder sind jeweils über zweite Proportionalitätsglieder 11, 11' an den (Eingang von Integratoren 12, 12' angeschlossen). Die Ausgangsgröße jedes Integrators ist an einem entsprechenden Summationsglied 13, 13' der am Komponentenwandler 6 abgegriffenen, jeweiligen Komponente des Spannungsvektors $\underline{U}'$ überlagert. Ferner kann vorgesehen sein, über gestrichelt eingezeichnete Leitungen 14, 14' und weitere Proportionalitätsglieder 15, 15' auch die am Komponentenwandler 9 abgegriffene, jeweilige Komponente des Stromvektors $\underline{I}'$ den Überlagerungsstellen 13, 13' zuzuführen. Von diesen Überlagerungsstellen 13, 13' führen die Leitungen 16, 16' zu der Steuereinrichtung 3.

Zunächst werden die Integrationsschaltungen 4, 4' und die vom Komponentenwandler 6 zu den Summationsgliedern 13, 13' führenden Leitungen 13a, 13a' nicht betrachtet und an den Proportionalitätsgliedern 11, 11' die Konstante k = 1 gesetzt. Die Anordnung entspricht dann der in der erwähnten DE-C-2 833 593 dargestellten Vorrichtung, wobei dort noch für die Integratoren 12, 12' eine besondere Nullpunktregelung vorgesehen ist, die auch für die Integratoren 12, 12' bei Fig. 1 vorteilhaft ist.

Für die Wirkungsweise der Vorrichtung sind die Komponentenwandler 6, 9, die lediglich die Bildung der kartesischen Komponenten der Strom- und Spannungsvektoren aus den entsprechenden Meßwerten für die Phasenspannungen und Phasenströme vollziehen, von keiner weiteren Bedeutung. Sie sind zwar, da sie im allgemeinen Operationsverstärker enthalten, die auf einem gegenüber den Phasenspannungen verhältnismäßig niedrigen Spannungspegel arbeiten, vorteilhaft auf der Ausgangsseite der Meßwandler angeordnet, wobei die Meßwandler einerseits der galvanischen Trennung der nachgeordneten Schaltungsteile von der Ständerspannung dienen, andereiseits auch den Ständerspannungspegel an den Pegel des nachgeordneten Schaltungsteils anpassen. Das Übertragungsverhältnis des Meßwandlers 5 ist mit ü bezeichnet. Die Bildung der kartesischen Komponenten kann — zumindest gedanklich — auch direkt für die Phasenspannungen vorgenommen werden, in diesem Falle wäre der Komponentenwandler 6 am Eingang der meßwandler bzw. Integrationsschaltungen anzuordnen. Unter der vorläufigen Voraussetzung, daß die Integrationsschaltungen 4, 4' nicht vorhanden sind, ergibt sich somit für den gewandelten Spannungsvektor $\underline{U}'$

$$\underline{U}' = \ddot{u} \cdot \underline{U}.$$

Für die Stromwandler 8, 8' sei die gleiche Proportionalität zwischen Eingangs- und Ausgangssignal angenommen, und an den Proportionalitätsgliedern 10, 10' sei als Proportionalitätsfaktor der Parameter des Sänderwiderstandes r eingestellt. Die Einstellung des Proportionalitätsfaktors r bzw. k · r kann auch bereits durch entsprechende Dimensionierung der Stromwandler 8, 8' bzw. des Komponentenwandlers 9, d. h. ohne eigene Proportionalitätsglieder, erfolgen.

Man erkennt, daß — wiederum unter der vorläufigen Annahme, daß die Elemente 4, 13a bzw. 4', 13a' nicht vorgesehen sind und k = 1 gesetzt ist — die vom Summationsglied 7 und dem Integrator 12 gebildete Integrationsschaltung sowie die Aufschaltung der Ausgangsgröße des Proportionalgliedes 15, dessen Konstante auf den Parameter x der Drehfeldmaschinen-Streuinduktivität eingestellt ist, eine Größe

$$\psi'_\alpha = \omega_N \cdot \int (U'_\alpha - r \cdot I'_\alpha)\, dt - x \cdot I'_\alpha$$

bildet, die (entsprechend dem Übertragungsverhältnis ü) der $\alpha$-Komponente des Läuferflusses $\underline{\psi}$ proportional ist und somit ein Abbild der $\alpha$-Komponente des gemäß der Beziehung (1) der Drehfeldmaschine zugeordneten Flusses ist und daher der Steuereinrichtung 3 über die Leitung 16 als Rechengröße für die $\alpha$-Komponente des Flusses zugeführt werden kann. Dasselbe gilt auch für die an der Leitung 16' zugeführte $\beta$-Komponente des Flusses.

Mittels dieser Flußkomponenten steuert die Steuereinrichtung 3 die Ständerspannung derart, daß ein bestimmter Flußsollwert eingehalten wird. Dies hat zur Folge, daß die Ständerspannung bei den vorgesehenen Werten für den Fluß mit abnehmender Drehzahl der Drehfeldmaschine auf eine abnehmende Frequenz und eine abnehmende Amplitude zugesteuert wird. Verallgemeinernd kann daher der Meßwandler 5, der als eine Stromerfassungseinrichtung 21 aufzufassende Stromwandler 8 mit dem nachgeschaltetem Proportionalglied 10 sowie die (« erste ») Integrationsschaltung 20 als eine Vorrichtung zum Bestimmen einer Rechengröße $\underline{\psi}'$ aufgefaßt werden, die einer mit einem Strom i und mit einer bei abnehmender Frequenz abnehmenden Spannung u gespeisten Last zugeordnet ist und eine von der Spannung u, dem Strom i und einem Parameter R gemäß der Beziehung ∫ (u + R · i) dt bestimmte Betriebsgröße der Last abbildet. Für den betrachteten Fall, daß als Last eine Drehfeldmaschine vorgesehen ist, ist dann für u die α-Komponente des Ständerspannungsvektors U, für i die α-Komponente des Ständerstromvektors I, für r = − R der negative Ständerwiderstand und für die Rechengröße ψ' die — zunächst unter Vernachlässigung der Streuspannung x · I gebildete — α-Komponente des Ständerflusses ψ zu setzen.

Diese Vorrichtung enthält somit :

a) einen eingangsseitig an die Spannung u angeschlossenen Meßwandler zur Bildung einer der Spannung u zugeordneten, von der Lastspannung galvanisch getrennten Eingangsgröße u',

b) eine den Laststrom i erfassende Strommeßeinrichtung 21 zur Bildung einer dem Produkt R · i proportionalen Eingangsgröß R · i' und

c) eine erste Integrationsschaltung 20 zur Integration einer die beiden Eingangsgrößen u' und R · i' beinhaltenden Größe.

Bei dem Betrieb einer derartigen Vorrichtung sinkt bei niedrigen Frequenzen der Eingangspegel des Meßwandlers 5 (im Fall einer als Last verwendeten Drehfeldmaschine also die effektive Phasenspannung) derart ab, daß der Übertragungsfehler des Meßwandlers 5 größer wird als der Pegel der Spannung u. Der Übertragungsfehler des Meßwandlers kann z. B. ein von Offset-Spannungen hervorgerufener Gleichanteil und/oder ein durch Meßungenauigkeiten hervorgerufener statistischer Meßfehler sein und macht sich bei einer Wandler-Eingangsspannung $u_0$ an dem Ausgangssignal u' als Abweichung von der Linearität zwischen u' und $u_0$, also als eine Störspannung $\Delta u$ entsprechend

$$u' = ü \cdot u_0 + \Delta u = ü \cdot u_0 \cdot \left(1 + \frac{\Delta u}{ü \cdot u_0}\right) \approx ü \cdot u_0\left(1 + \frac{\Delta u}{u'}\right),$$

bemerkbar. Der relative Fehler

$$\frac{\Delta u}{u'} \approx \frac{\Delta u}{ü u_0}$$

ist vom Übertragungsverhältnis ü und der momentanen Lastspannung $u = u_0$ abhängig. Das Übertragungsverhältnis ist so gewählt, daß z. B. die Operationsverstärker des nachgeordneten Schaltungsteils ihre volle Ausgangsspannung von 10 V erreichen, wenn die Lastspannung u bei der Nennfrequenz der Last ihren vollen Effektivwert von 380 V entsprechend einer Spitzenspannung von 537 V erreicht. Für ü ist daher der Wert von 0,0186 zu wählen. Entsprechend der gewünschten Rechengenauigkeit ist für den (auf die Wandler- Ausgangsspannung u' bezogenen) Fehler $\Delta u/u'$ (« relativer Eingangsfehler der Integrationsschaltung ») bzw. den (auf die Wandler-Eingangsspannung $u_0$ bezogenen) Fehler $\Delta u/u_0$ (« relativer Übertragungsfehler des Meßwandlers ») ein Maximalwert

$$\left(\frac{\Delta u}{u'}\right)_{max}$$

bzw.

$$\left(\frac{\Delta u}{u_0}\right)_{max} = ü\left(\frac{\Delta u}{u'}\right)_{max}$$

zulässig und es gilt :

$$u > \frac{\Delta u}{ü \cdot \left(\frac{\Delta u}{u'}\right)_{max}} = \frac{\Delta u}{\left(\frac{\Delta u}{u_0}\right)_{max}}.$$

Für niedrigere Frequenzen ist diese Bedingung unterschritten und es kann zu unerwünschten Fehlbestimmungen von ψ' kommen. Wird dagegen die Lastspannung u am Meßwandlereingang um den Faktor k verstärkt (d. h. $u_0 = k \cdot u$ gesetzt), so gilt

$$u' = ü \cdot u_0 + \Delta u = k \cdot ü \cdot u\left(1 + \frac{\Delta u}{ü \cdot u_0}\right).$$

Der maximal zulässige relative Fehler wird jetzt erst unterschritten, wenn die Wandler-Eingangsspannung $u_0 = k \cdot u$ den Wert

$$\Delta u \Big/ \left(\frac{\Delta u}{u_0}\right)_{max}$$

unterschreitet. Der Bereich für die zulässigen Lastspannungen ist jetzt durch die Bedingung

5

$$u_0 > \frac{\Delta u}{\left(\dfrac{u}{u_0}\right)_{max}} \qquad \text{bzw.} \qquad u > \frac{1}{k}\frac{\Delta u}{\left(\dfrac{\Delta u}{u_0}\right)_{max}}$$

gegeben. Soll also die Vorrichtung bis zu einer unteren Grenzfrequenz $\omega_{min}$ bzw. der entsprechenden unteren Lastspannung $u_{min}$ betrieben werden, so ist entsprechend dem absoluten Übertragungsfehler $\Delta u$ und dem maximal zulässigen, auf die Wandlereingangsspannung $u_0$ bezogenen relativen Übertragungsfehler

$$\left(\frac{\Delta u}{u_0}\right)_{max}$$

für k mindestens der Wert

$$k = \frac{\Delta u}{u_{min}}\Big/\left(\frac{\Delta u}{u_0}\right)_{max}$$

zu wählen. Andererseits darf die Wandlerausgangsspannung $u' = k \cdot \ddot{u} \cdot u$ den oben angeführten Grenzpegel von z. B. 10 V nicht überschreiten, so daß die Multiplikation mit dem Faktor k nur bei niedrigen Frequenzen vorgenommen werden darf.

Gemäß der Erfindung sind die oben aufgeführten Merkmale a) — c) folgendermaßen zu ergänzen :

d) eine dem Meßwandler 5 vorgeschaltete (« zweite ») Integrationsschaltung 4 ist auf eine Übertragungsfunktion $k/(1 + s \cdot k/\omega_n)$ ausgelegt, wobei s der Laplace-Operator, $\omega_N$ eine aus Normierungsgründen eingeführte, vorgegebene Bezugsfrequenz der Last und k ein vorgegebener Proportionalitätsfaktor ist, der entsprechend der im unteren Frequenzbereich geltenden Bedingung

$$k \geqslant \frac{\Delta u}{u}\Big/\left(\frac{\Delta u}{u_0}\right)_{max}$$

gewählt ist ;

e) die (« erste ») Integrationsschaltung 20 ist derart ausgebildet, daß sie die Ausgangsgröße

$$\omega_N/k \cdot \int (u' + k \cdot R \cdot i')\, dt$$

bildet ;

f) die vom Meßwandler gelieferte Eingangsgröße $u'$ und die Ausgangsgröße der ersten Integrationschaltung 20 sind einem Summationsglied 13 zugeführt, an dem die Rechengröße $\psi'$ abgegriffen ist.

Mit der Erfindung wird die Eingangsamplitude des Wandlers frequenzabhängig angehoben, wobei bei hohen Frequenzen der proportionalitätsfaktor klein, bei niedrigen Frequenzen groß ist. Das übertragene Signal überschreitet dabei nicht den zulässigen Spannungspegel des nachgeordneten Schaltungsteils. Durch geeignete Schaltungsmaßnahmen wird hinter dem Wandler diese amplitudenabhängige Verzerrung wieder kompensiert. Darüber hinaus findet die frequenzabhängige Amplitudenverstärkung nicht durch eine Umschaltung eines Proportionalgliedes statt, worduch ein diskontinuierlicher Übergang von einem Meßbereich in einen anderen vermieden wird. Vielmehr wird diese Bereichsanpassung durch eine Integrationsschaltung, die z. B. vorteilhaft aus passiven Bauelementen aufgebaut sein kann, und entsprechende einfache Maßnahmen hinter dem Wandler erreicht. Eine diskontinuierliche Umschaltung des Proportionalitätsfaktors würde auf der Lastspannungsseite Schaltungselemente erfordern, die sich z. B. aus Schaltern und Operationsverstärkern, die an den bei Vollaussteuerung vorliegenden hohen Lastspannungspegel angeglichen sein müssen, nur schwer verwirklichen ließe. Eine derartige Integrationsschaltung ruft neben der Amplitudenverstärkung auch eine Phasenverschiebung hervor, die aber durch die gleichen Maßnahmen hinter dem Wandler wieder rückgängig gemacht werden kann.

Betrachtet man den Frequenzgang der ersten Integrationsschaltung 20 und des Summationsgliedes 13, so erhält man für dieses Übertragungsglied die Übertragungsfunktion

$$u' + \omega_N/k \cdot 1/s \cdot (u' + k \cdot R \cdot i') =$$

$$\frac{\omega_N}{s}\left(\frac{1 + s \cdot k/\omega_N}{k} \cdot u' + R \cdot i'\right)$$

die offensichtlich den Frequenzgang der zweiten Integrationsschaltung so kompensiert, daß ein

entsprechend dem Übertragungsverhältnis proportionales Abbild der entsprechenden Betriebsgröße der Last erhalten wird.

Für den im besonderen betrachteten Fall der Drehfeldmaschine, bei dem der Läuferfluß als Betriebsgröße ($\psi$) noch durch die Streuspannung $- x \cdot \underline{i}$ bestimmt ist, kann die Ausgangsgröße der Strommeßeinrichtung mit dem Gewicht $k \cdot R$ (entsprechend dem Ständerwiderstand $r = - R$) gewichtet dem Summationsglied 7 und mit dem Gewicht X (entsprechend der Streuinduktivität $x = - X$) gewichtet über das Proportionalglied 15 dem Summationsglied 13 zugeführt werden. Da eines der beiden für die Gewichtung in Fig. 1 vorgesehenen Proportionalglieder 10 und 15 bereits durch entsprechende Auslegung des Stromwandlers 8 bzw. Komponentenwandlers 9 durch das Übertragungsverhältnis dieser Bauglieder verwirklicht werden kann, ist hierfür u. U. nur ein Proportionalglied für die Ausgangsgröße der Strommeßeinrichtung erforderlich.

Wie bereits erwähnt wurde, kann die Integrationsschaltung 4 durch eine entsprechende passive Beschaltung, z. B. einen Kondensator mit parallelem Widerstand, am Eingang des Meßwandlers realisiert werden, wie dies in Figur 2 dargestellt ist. Die Ausgangsspanung u' ist galvanisch von der Eingangsspannung getrennt und durch das Verstärkungsverhältnis eines Optokopplers 30 bestimmt, der bei einem Eingangsstrom $I_{in}$ von 0,01 mA den gewünschten Spannungspegel von 10 V für Vollaussteuerung bei Nennfrequenz (50 Hz) erzeugt. Das Übertragungsverhältnis des Optokopplers ist somit durch 10 $V/\sqrt{2} \cdot 380$ V $= 0,018\,6$ gegeben. Mit sinkender Eingangsspannung des Optokopplers steigt der Einfluß des meßfehlers und erreicht bei einer Eingangsspannung von etwa 53,7 V (10 % der Nennspannung) für den Optokoppler den maximal zulässigen relativen Fehler. Dies wäre ohne Verwendung der erfindungsgemäßen Integrationsschaltung bei einer Frequenz $\omega_{gr}$ von etwa 5 Hz erreicht. Durch die Eingangsbeschaltung des Optokopplers mit den Widerständen R1 bis R4 und der Kapazität C wird jedoch erreicht, daß die Lastspannung bei Frequenzen $\omega$ unter etwa $\omega_{gr} = 5$ Hz um den Faktor k erhöht wird und der maximal zulässige Übertragungsfehler erst bei der wesentlich niedrigeren Frequenz $\omega' = \omega_{gr}/k$ erreicht wird. Z. B. kann für den Wert $k = 10$ die passive, integrierende Eingangsbeschaltung des Optokopplers durch $R_1 = 1,6$ M$\Omega$, $R_2 = 47$ k$\Omega$, $R_3 = 66$ k$\Omega$, $R_4 = 56$ k$\Omega$ und $C = 1$ $\mu$F gewählt werden und dadurch der maximale Steuerbereich bis auf eine Frequenz von 0,5 Hz entsprechend einer effektiven Lastspannung von 3,8 V ausgedehnt werden.

Dieser als Meßwandler verwendete Optokoppler 30 ist in Fig. 2 in Verbindung mit einer Rechenschaltung 31 gezeigt, die im Gegensatz zur Integrationsschaltung 20 in Fig. 1 keinen Integrator für die am Meßwandlerausgang abgegriffene Spannung u' aufweisen muß. In diesem Fall ist die Kompensierung des Frequenzganges der dem Meßwandler vorgeschalteten integrierenden Schaltung 32 nicht auf die in Fig. 2 gezeigte, einfache Weise möglich. Soll auch in diesem Fall eine Rechengröße bestimmt werden, die einer mit abnehmender Frequenz abnehmenden Meßspannung u zugeordnet ist, so sieht die Erfindung für den Fall, daß der Übertragungsfehler des Meßwandlers bezogen auf die Meßspannung u im unteren Frequenzbereich den zulässigen maximalen relativen Meßfehler überschreitet, von daß dem Meßwandler eine integrierende Schaltung vorgeordnet ist mit der Übertragungsfunktion

$$k \left/ \left( 1 + s \cdot \frac{k}{\omega_N} \right) \right. ,$$

wobei der Proportionalitätsfaktor k wiederum so gewählt ist, daß bei niedrigen Frequenzen die um den Faktor k verstärkte Ausgangsspannung der Integrationsschaltung größer ist als der Quotient aus dem absoluten Meßfehler und dem maximal zulässigen relativen Fehler. Dem Meßwandler ist jetzt eine der Rechenschaltung 31 vorgeordnete differenzierende Schaltungsanordnung mit dem Zeitverhalten

$$\frac{1}{k} \cdot \left( 1 + s \cdot \frac{k}{\omega_N} \right)$$

nachgeordnet.

In Fig. 2 ist diese differenzierende Schaltungsanordnung 33 dadurch gegeben, daß die vom Meßwandler dem nachgeordneten Schaltungsteil eingegebene Eingangsspannung u' einerseits direkt und andererseits über ein Differenzierglied 34 einem Summationsglied 35 zugeführt ist. Das Differenzierglied 34 (Übertragungsfunktion $s \cdot k/\omega_N$) und das Summationsglied 35 wirken als Vorhalteglied und können entsprechend auch durch ein einziges Bauglied ersetzt werden. Ein nachfolgendes Proportionalglied 36 kompensiert die Proportionalverstärkung der integrierenden Schaltung 32. Dieses Proportionalglied kann selbstverständlich auch durch eine entsprechende Eingangsbeschaltung der Rechenschaltung 31 verwirklicht sein.

Selbstverständlich kann als Rechenschaltung 31 auch ein Integrator entsprechend dem Integrator 12 in Fig. 1 verwendet werden. Es ist somit auch möglich, auf diese Weise die bereits erwähnte Steuerung einer Drehfeldmaschine durchzuführen. So kann z. B. der ohmsche Ständerspannungsabfall entsprechend Fig. 1 durch ein Proportionalglied 10 an der Überlagerungsstelle 35 zugeführt werden.

**Patentansprüche**

1. Vorrichtung zum Bestimmen einer Rechengröße $\psi'$, die einer mit einem Strom i und mit einer bei abnehmender Frequenz abnehmenden Spannung u gespeisten Last zugeordnet ist und eine von der Spannung u, dem Strom i und einem Parameter R gemäß der Beziehung $\int(u + R \cdot i) \cdot dt$ bestimmte Betriebsgröße der Last, insbesondere den Flußvektor ($\psi$) einer Drehfeldmaschine, abbildet, mit

a) einem eingangsseitig an die Spannung u angeschlossenen Meßwandler (5) zur Bildung einer der Spannung u zugeordneten, von ihr galvanisch getrennten Eingangsgröße u',

b) einer den Laststrom i erfassenden Strommeßeinrichtung (21) zur Bildung einer dem Produkt R $\cdot$ i proportionalen Eingangsgröße R $\cdot$ i' und

c) einer ersten Integrationsschaltung (20) zur Integration einer die beiden Eingangsgrößen (u', R $\cdot$ i') beinhaltenden Größe,

dadurch gekennzeichnet, daß

d) die Spannung u dem Meßwandler (5) über einer vorgeschaltete zweite Integrationsschaltung (4) zugeführt ist, die eine Übertragungsfunktion

$$\frac{k}{1 + s \cdot \dfrac{k}{\omega_N}}$$

aufweist, wobei s der Laplace-Operator und $K/\omega_N$ ein auf eine dem Normalbetrieb der Last zugeordnete Frequenz $\omega_N$ normierter und derart gewählter Proportionalitätsfaktor ist, daß auch bei niedrigen Frequenzen, bei denen der relative Übertragungsfehler $\Delta u/u$ des Meßwandlers (5), der definiert ist als Quotient aus dem z. B. durch Meßfehler und/oder eine Offsetspannung des Meßwandlers bedingten absoluten Übertragungsfehler $\Delta u$ des Meßwandlers und aus der Spannung u, größer wird als der für die Abbildung der Betriebsgröße zulässige Maximalwert $(\Delta u/u_0)_{max}$ des relativen Übertragungsfehlers des Meßwandlers, der definiert ist als Quotient aus dem absoluten Übertragungsfehler $\Delta u$ und der minimal zulässigen Eingangsspannung $u_0$ des Meßwandlers, die entsprechend dem Proportionalitätsfaktor k verstärkte Spannung u größer als der (Quotient $\Delta u/(\Delta u/u_0)_{max}$ aus dem absoluten Übertragungsfehler $\Delta u$ und dem zulässigen Maximalwert $(\Delta u/u_0)_{max}$ oder gleich diesem Quotienten ist,

e) die erste Integrationsschaltung (20) die Ausgangsgröße

$$\frac{\omega_N}{k} \cdot \int (u' + k \cdot R \cdot i') \, dt$$

bildet und

f) die Rechengröße $\psi'$ an einem Summationsglied (13) für die vom Meßwandler gelieferte Eingangsgröße u' und die Ausgangsgröße der ersten Integrationsschaltung (20) abgegriffen ist.

2. Vorrichtung nach Anspruch 1, bei der die Betriebsgröße, insbesondere eine Fluß komponente $\psi = \int(u - r \cdot i)dt - x \cdot i$, proportional zu $\int(u + R \cdot i)dt + x \cdot i$, unter Verwendung eines Parameters X bestimmt ist, dadurch gekennzeichnet, daß unter Verwendung wenigstens eines Proportionalgliedes (15) die Ausgangsgröße der Strommeßeinrichtung (21) mit dem Gewicht K $\cdot$ R gewichtet der ersten Integrationsschaltung (20) und mit dem Gewicht X gewichtet dem Summationsglied (13) zugeführt ist.

3. Vorrichtung zum Bestimmen einer Rechengröße, die funktional abhängig ist von einer mit abnehmender Frequenz abnehmenden Meßspannung u, mit

a) einem eingangsseitig an die Meßspannung u angeschlossenen Meßwandler (30) und

b) einer dem Meßwandler nachgeordneten Rechenschaltung (31), dadurch gekennzeichnet, daß

c) dem Meßwandler eine integrierende Schaltung (32) vorgeschaltet ist mit der Übertragungsfunktion

$$\frac{k}{1 + s \cdot \dfrac{k}{\omega_N}}$$

wobei s der Laplace-Operator , $\omega_N$ eine dem Normalbetrieb zugeordnete Nennfrequenz und k ein derart gewählter Proportionalitätsfaktor ist, daß auch bei derart niedrigen Frequenzen, bei denen der relative Übertra gungsfehler $\Delta u/u$ des Meßwandlers (30), der definiert ist als Quotient aus dem z. B. durch Meßfehler und/oder eine Offsetspannung des Meßwandlers bedingten absoluten Übertragungsfehler $\Delta_u$ des Meßwandlers und aus der Spannung u, größer wird als der für die Abbildung der Betriebsgröße zulässige Maximalwert $(\Delta u/u_0)_{max}$ des relativen Übertragungsfehlers $\Delta u/u_0$ des Meßwandlers, der definiert ist als Quotient aus dem absoluten Übertragungsfehler $\Delta u$ und der minimal zulässigen Eingangsspannung $u_0$ des Meßwandlers, die um den Proportionalitätsfaktor k verstärke Spannung u größer als der Quotient $\Delta u/(\Delta u/u_0)_{max}$ aus dem absoluten Übertragungsfehler $\Delta u$ und dem zulässigen Maximalwert $(\Delta u/u_0)_{max}$ ist, und

d) dem Meßwandler eine differenzierende Schaltungsanordnung (33) mit der Übertragungsfunktion

$$\frac{1}{k} \cdot \left( 1 + s \frac{k}{\omega_N} \right)$$

nachgeschaltet ist.

4. Verwendung einer Vorrichtung nach einem der Ansprüche 1 bis 3 als Flußrechner zum Bestimmen einer dem Fluß einer Drehfeldmaschine zugeordneten Rechengröße.

## Claims

1. A device for determining a calculating value $\psi'$ which is assigned to a load fed with a current i and a voltage u which decrease with decreasing frequency, and represents an operating value of the load, in particular the flux vector ($\underline{\psi}$) of a rotating field machine, which is determined from the voltage u, the current i and a parameter R in accordance with the relation

$$\int (u + R \cdot i) \cdot dt : -$$

comprising

a) a measuring transformer (5) connected to the voltage u at the input end top form an input value u' assigned to the voltage u and electrically isolated therefrom,

b) a current measuring device (21) which determines the load current i and serves to form an input value R · i which is proportional to the product R · i' and

c) a first integration circuit (20) for the integration of a value which comprises the two input values (u', R · i'), characterised in that

d) the voltage u is fed to the measuring transformer (5) by means of a preceding second integration circuit (4) which has a transfer function

$$\frac{k}{1 + s \cdot \dfrac{k}{\omega_N}}$$

where s is the Laplace operator and $k/\omega_N$ a proportionality factor which is gauged to a frequency $\omega_N$ assigned to the normal operation of the load, and selected to be such that even in the case of low frequencies, at which the relative transfer error $\Delta u/u$ of the measuring transformer (5), defined as a quotient from the absolute transfer error $\Delta u$ of the measuring voltage, which is for example conditional on the measuring error and/or an offset voltage of the measuring transformer, and from the voltage u, becomes greater than the maximal value $(\Delta u/u_0)_{max}$ of the relative transfer error of the measuring transformer permissible for the representation of the operating value and defined as quotient from the absolute transfer error $\Delta u$ and the minimum permissible input voltage $u_0$ of the measuring transformer, the voltage u reinforced in accordance with the proportionality factor k is greater than the quotient $\Delta u/(\Delta u/u_0)_{max}$ from the absolute transfer error $\Delta u$ and the permissible maximal value $(\Delta u/u_0)_{max}$, or equals this quotient,

e) the first integration circuit (20) forms the output value

$$\frac{\omega_N}{k} \cdot \int (u' + k \cdot R \cdot i') \, dt \qquad \text{and}$$

f) the calculating value $\psi$ is tapped at a summation element (13) for the input value u', which is supplied from the measuring transformer, and the output value of the first integration circuit (20).

2. A devicè as claimed in Claim 1, wherein the operating values, in particular a flux component $\psi = \int(u - r \cdot i)dt - x \cdot i$, is determined so as to be proportional to $\int(u + R \cdot i)dt + X \cdot i$, employing a parameter X, characterised in that, employing at least one proportional element (15), the output value of the current measuring device (21) weighed with the weight k · R is fed to the first integration circuit (20) and is fed to the summation element (13) weighed with the weight X.

3. A device for determining a calculating value which is functionally dependent on a measuring voltage u which decreases with decreasing frequency, comprising

a) a measuring transformer (30) connected to the measuring voltage u at the input end and

b) a calculating circuit (31) connected following the measuring transformer, characterised in that

c) the measuring transformer is preceded by an integrated circuit (32) with a transfer function

$$\frac{k}{1 + s \cdot \dfrac{k}{\omega_N}}$$

where s is the Laplace operator, $\omega_N$ is a reference frequency and k is a proportionality factor selected to be such that even in the case of such low frequencies, at which the relative transfer error $\Delta u/u$ of the measuring transformer (30), which is defined as quotient from the absolute transfer error $\Delta u$ of the measuring transformer, which is, for example, conditional on the measuring error and/or an offset voltage of the measuring transformer, and from the voltage u, becomes greater than the maximum value $(\Delta u/u_0)_{max}$ of the relative transfer error $\Delta u/u_0$ of the measuring transformer, which is permissible for the representation of the operating value and which is defined as quotient from the absolute transfer error $\Delta u$ and the minimum permissible input voltage $u_0$ of the measuring transformer, the voltage u, which is reinforced by the proportionality factor k, is greater than the quotient $\Delta u/(\Delta u/u_0)_{max}$ from the absolute transfer error $\Delta u$ and the permissible maximum value $(\Delta u/u_0)_{max}$, and

d) the measuring transformer is followed by a differentiating circuit (33) with the transfer function

$$\frac{1}{k} \cdot \left( 1 + s \frac{k}{\omega_N} \right).$$

4. The use of a device as claimed in one of Claims 1 to 3 as a flux calculator for determining the calculating value assigned to the flux of a rotating field machine.


**Revendications**

1. Dispositif pour déterminer une grandeur de calcul ($\psi$), qui est associé à une charge alimentée par un courant i et sous une tension u diminuant lorsque la fréquence diminue, et qui représente une grandeur de service de la charge, notamment le vecteur flux ($\psi$) d'une machine à champ tournant, déterminée par la tension u, le courant i et un paramètre R conformément à la relation $\int(u + R \cdot i)\,dt$, et comportant

a) un transformateur de mesure (5) raccordé du côté entrée à la tension u et servant à former une grandeur d'entrée u' associée à la tension u et séparée galvaniquement de cette dernière,

b) un dispositif ampèremétrique (21) déterminant l'intensité i de la charge et servant à former la grandeur d'entrée $R \cdot i'$, proportionnelle au produit $R \cdot i$, et

c) un premier circuit d'intégration (20) servant à intégrer une grandeur incluant les deux grandeurs d'entrée (u', $R \cdot i'$),
caractérisé par le fait que

d) la tension u du transformateur de mesure (5) est envoyée par l'intermédiaire d'un second circuit d'intégration (4) branché en amont et qui possède une fonction de transfert

$$\frac{k}{1 + s \cdot \dfrac{k}{\omega_N}}$$

s désignant l'opérateur de Laplace et $k/\omega_N$ étant un facteur de proportionnalité normalisé par rapport à une fréquence $\omega_N$ associée au fonctionnement normal de la charge et étant choisi de telle sorte que même aux basses fréquences, pour lesquelles l'erreur relative de transformation $\Delta u/u$ du transformateur de mesure (5), qui est définie en tant que le coefficient de l'erreur de transformation absolue ($\Delta u$) du transformateur de mesure, conditionnée par exemple par l'erreur de mesure et/ou une tension résiduelle du transformateur de mesure, et de la tension u, est supérieure à la valeur maximale $(\Delta u/u_0)_{max}$, admissible pour la représentation de la grandeur de service, de l'erreur relative de transformation du transformateur de mesure, qui est définie comme étant le coefficient de l'erreur absolue de transformation $\Delta u$ et de la tension d'entrée minimale admissible $u_0$ du transducteur de mesure, la tension u amplifiée conformément au facteur de proportionnalité k est supérieure au coefficient $\Delta u/(\Delta u/u_0)_{max}$ entre l'erreur absolue de transmission $\Delta u$ et la valeur maximale admissible $(\Delta u/u_0)_{max}$ ou est égale à ce quotient,

e) le premier circuit d'intégration (20) forme la grandeur de sortie

$$\frac{\omega_N}{k} \cdot \int (u' + k \cdot R \cdot i')\,dt, \qquad \text{et}$$

f) la grandeur de calcul $\psi'$ est prélevée sur un organe de sommation (13) pour la grandeur d'entrée u' délivrée par le transformateur de mesure et la grandeur de sortie du premier circuit d'intégration (20).

2. Dispositif suivant la revendication 1, dans lequel la grandeur de service, notamment une composante de flux $\psi = \int(u - r'i)\,dt - x \cdot i$, est déterminée d'une manière proportionnelle à $\int(u + R \cdot i)\,dt + X \cdot i$, moyennant l'utilisation d'un paramètre X, caractérisé par le fait que moyennant l'utilisation d'au moins un circuit à action proportionnelle (15), la grandeur de sortie du dispositif ampèremétrique (21) est pondérée par le poids $k \cdot R$ du premier circuit d'intégration (20) et est envoyée, en étant pondérée par le poids X, au circuit de sommation (13).

3. Dispositif pour déterminer une grandeur de calcul, qui dépend, du point de vue fonctionnel, d'une tension de mesure u diminuant lorsque la fréquence diminue, et comportant

a) un transformateur de mesure (30) raccordé sur le côté entrée à la tension de mesure u, et

b) un circuit de calcul (31) monté en aval du transformateur de mesure, caractérisé par le fait que

c) en amont du transformateur de mesure se trouve branché un circuit intégrateur (32) possédant la fonction de transfert

$$\frac{k}{1 + s \cdot \dfrac{k}{\omega_N}}$$

s étant l'opérateur de Laplace, $\omega_N$ une fréquence nominale associée au fonctionnement normal et k un facteur de proportionalité choisi de telle sorte que même dans le cas de basses fréquences pour lesquelles l'erreur relative de transformation $\Delta u/u$ du transformateur de mesure (5), qui est définie en tant que coefficient de l'erreur de transformation absolue ($\Delta u$) du transformateur de mesure, conditionnée par exemple par l'erreur de mesure et/ou une tension résiduelle du transformateur de mesure, et la tension u, est supérieure à la valeur maximale $(\Delta u/u_0)_{max}$, admissible pour la représentation de la grandeur de service, de l'erreur relative de transformation du transformateur de mesure, qui est définie comme étant le coefficient de l'erreur absolue de transformation $\Delta u$ et la tension d'entrée minimale admissible $u_0$ du transformateur de mesure, la tension u amplifiée conformément au facteur de proportionnalité k est supérieure au coefficient $\Delta u/(\Delta u(u_0)_{max}$ entre l'erreur absolue de transformation $\Delta u$ et la valeur maximale admissible $(\Delta u/u_0)_{max}$ ou est égale à ce quotient, et

d) qu'un montage différentiateur (33) possédant la fonction de transfert

$$\frac{1}{k} \cdot \left( 1 + s \frac{k}{\omega_N} \right)$$

est branché en aval du transformateur de mesure.

4. Mise en œuvre d'un dispositif suivant l'une des revendications 1 à 3 en tant que calculateur de flux pour déterminer une grandeur de calcul associée au flux d'une machine à champ tournant.

0 068 394

FIG 1

FIG 2